# EUROPEAN PATENT SPECIFICATION

(11) **EP 3 860 014 B1**
(45) Date of publication and mention of the grant of the patent: **13.11.2024**
(21) Application number: 19867721.3
(22) Date of filing: 25.09.2019
(51) Int. Cl.: H04L 69/04, H04L 41/04, H04L 69/22, H04L 69/321, H04L 69/324, H03M 7/30, H03M 7/40, H04W 28/06, H04W 8/24

(54) **CONTROL PLANE MESSAGE TRANSMISSION METHOD AND DEVICE**
VERFAHREN UND VORRICHTUNG ZUR NACHRICHTENÜBERTRAGUNG AUF STEUEREBENE
PROCÉDÉ ET DISPOSITIF DE TRANSMISSION DE MESSAGE DE PLAN DE COMMANDE

(30) Priority: 26.09.2018 CN 201811126071
(43) Date of publication of application: 04.08.2021
(73) Proprietor: Datang Mobile Communications Equipment Co., Ltd., Beijing 100083 (CN)
(72) Inventor: ZHANG, Huiying, Beijing 100191 (CN); QUAN, Haiyang, Beijing 100191 (CN); SUN, Jiancheng, Beijing 100191 (CN)
(74) Representative: Burger, Hannes
(86) International application number: PCT/CN2019/107778
(87) International publication number: WO 2020/063656

(56) References cited:
- WO-A1-2017/190541
- CN-A- 101 175 300
- CN-A- 105 812 094
- CN-A- 105 978 668
- CN-A- 107 079 005
- CN-A- 108 347 468
- US-A1- 2015 085 835
- MEDIATEK INC: "Summary of email discussion [99bis#29][LTE/UDC] Operator", vol. RAN WG2, no. Reno, Nevada, USA; 20171127 - 20171201, 17 November 2017 (2017-11-17), XP051372542, Retrieved from the Internet <URL:http://www.3gpp.org/ftp/tsg%5Fran/WG2%5FRL2/TSGR2%5F100/Docs/> [retrieved on 20171117]

## Description

### TECHNICAL FIELD

Embodiments of the present disclosure relate to the technical field of communications, and in particular to a transmission method and a transmission device for a control plane message.

### BACKGROUND

In a fifth-generation mobile communication technology (fifth-generation, 5G) system, since there are a large quantity of frequency band combinations, sizes of some signaling messages (such as a message about capability information of a user equipment) are very large, which exceed the limit of the maximum length (9000 bytes) of a packet data convergence protocol (Packet Data Convergence Protocol, PDCP) protocol data unit (Protocol Data Unit, PDU).

Therefore, a transmission mechanism for a control plane message which is relatively large (for example, exceeding the maximum length of the PDCP PDU) is needed. "Summary of email discussion [99bis#29][LTE/UDC] Operator controlled dictionary issue [MTK]" (3GPP TSG-RAN WG2 #100; MediaTek Inc.; R2-1713907) discusses the behaviour and procedure for operator controlled pre-defined dictionary used in UDC.
CN105812094A provides a data processing method, which includes determining to-be-compressed compression fields from first effective load of first data to be sent; according to the mapping relation of high frequency fields corresponding to the compression fields and the field serial numbers, determining the field serial numbers corresponding to the compression fields one by one; encoding according to the first effective load, the position of each compression field in the first effective load and the field serial number of each compression field, to obtain second data; sending the second data obtained through encoding to a receiving end.
WO2017/190541A1 provides a dictionary information synchronization method, which includes: a compression end sends dictionary information to a decompression end, where the dictionary information includes a dictionary mapping relation between a high frequency field and a field number; and the compression end sets the state of the dictionary mapping relation to be a valid state when the compression end receives a feedback message sent by the decompression end within a set feedback time, where the feedback message is used for indicating that the decompression end has successfully received the dictionary information.

### SUMMARY

Embodiments of the present disclosure, as defined in the appended claims, provide a transmission method and a transmission device for a control plane message, to solve the transmission problem of the control plane message which is relatively large (for example, exceeding the maximum length of the PDCP PDU).

According to a first aspect of the embodiments of the present disclosure, a method for transmitting a control plane message is provided according to claim 1, which is applied to a transmitting end.

Optionally, the identification information of the dictionary is included in a packet data convergence protocol (PDCP) header.

Optionally, the identification information of the dictionary is included in a radio resource control (RRC) message.

According to the invention, the transmitting, to the receiving end, the control plane message that is compressed by using the dictionary and the identification information of the dictionary includes: transmitting the control plane message that is compressed by using the dictionary and the identification information of the dictionary to the receiving end through a dedicated signaling bearer.

According to the invention, before the transmitting the control plane message that is compressed by using the dictionary and the identification information of the dictionary to the receiving end through the dedicated signaling bearer, the method further includes: obtaining the dedicated signaling bearer configured by the receiving end, or, configuring the dedicated signaling bearer for the receiving end.

Optionally, before the compressing the control plane message by using the dictionary supported by the transmitting end, the method further includes: storing, in the transmitting end, only dictionaries supported by the transmitting end, or, storing, in the transmitting end, all dictionaries existing in a network.

According to a second aspect of the embodiments of the present disclosure, a method for receiving a control plane message is provided according to claim 6, which is applied to a receiving end.

Optionally, the identification information of the dictionary is included in a packet data convergence protocol (PDCP) header.

Optionally, the identification information of the dictionary is included in a radio resource control (RRC) message.

According to the invention, the receiving, from the transmitting end, the control plane message that is compressed by using the dictionary and the identification information of the dictionary includes: receiving, through a dedicated signaling bearer, from the transmitting end, the control plane message that is compressed by using the dictionary and the identification information of the dictionary.

According to the invention, before the receiving, through the dedicated signaling bearer, from the transmitting end, the control plane message that is compressed by using the dictionary and the identification information of the dictionary, the method further includes: configuring the dedicated signaling bearer for the transmitting end, or, obtaining the dedicated signaling bearer configured by the transmitting end.

Optionally, before the receiving, from the transmitting end, the control plane message that is compressed by using the dictionary and the identification information of the dictionary, the method further includes: storing, in the receiving end, only dictionaries supported by the receiving end, or, storing, in the receiving end, all dictionaries existing in a network.

According to a third aspect of the embodiments of the present disclosure, a transmitting end is provided according to claim 9.

According to the invention, the transmitting module is configured to transmit the control plane message that is compressed by using the dictionary and the identification information of the dictionary to the receiving end through a dedicated signaling bearer.

According to a fourth aspect of the embodiments of the present disclosure, a receiving end is provided according to claim 13.

According to the invention, the receiving module is configured to receive, through a dedicated signaling bearer, from the transmitting end, the control plane message that is compressed by using the dictionary and the identification information of the dictionary.

### BRIEF DESCRIPTION OF THE DRAWINGS

Through reading detailed descriptions of optional embodiments in the following, various other advantages and benefits will become clear to those of ordinary skill in the art. The drawings are only used for the purpose of illustrating optional embodiments, and are not considered as a limitation to the present disclosure. Moreover, in the drawings, the same reference symbols are used to denote the same components. In the drawings:
FIG. 1 is a schematic diagram of an architecture of a radio communication system according to embodiments of the present disclosure;
FIG. 2 is a schematic diagram of a method for transmitting a control plane message according to embodiments of the present disclosure;
FIG. 3 is a schematic diagram of a method for receiving a control plane message according to embodiments of the present disclosure;
FIG. 4 is a second schematic diagram of a method for transmitting a control plane message according to embodiments of the present disclosure;
FIG. 5 is a second schematic diagram of a method for receiving a control plane message according to embodiments of the present disclosure;
FIG. 6 is a schematic diagram of a transmission method for a control plane message according to embodiments of the present disclosure;
FIG. 7 is a schematic structural diagram of a transmitting end according to embodiments of the present disclosure;
FIG. 8 is a schematic structural diagram of a receiving end according to embodiments of the present disclosure;
FIG. 9 is a second schematic diagram of a transmitting end according to embodiments of the present disclosure;
FIG. 10 is a second schematic diagram of a receiving end according to embodiments of the present disclosure;
FIG. 11 is a third schematic diagram of a transmitting end according to embodiments of the present disclosure; and
FIG. 12 is a third schematic diagram of a receiving end according to embodiments of the present disclosure.

### DETAILED DESCRIPTION

The technical solutions in embodiments of the present disclosure are described clearly and completely in conjunction with drawings in the embodiments of the present disclosure. Apparently, the described embodiments are merely a part of rather than all the embodiments of the present disclosure. All other embodiments obtained by a person ordinary skilled in the art based on the embodiments of the present disclosure without any creative efforts fall within the protection scope of the present disclosure.

The term "include" in the specification and claims of the present disclosure and any variants thereof are meant to cover non-exclusive inclusion. For example, a process, method, system, product or device including a series of steps or units is not limited to those steps or units specifically listed below, and may include other steps or units that are not specifically listed or that are inherent in the process, method, product, or device. In addition, the use of "and/or" in the specification and claims refers to at least one of the connected objects, for example, A and/or B refers to three cases: only A being included, only B being included, or, both A and B being included.

In the embodiments of the present disclosure, terms such as "exemplary" or "for example" are used to represent examples, illustrations, or explanations. Any embodiment or design solution described as "exemplary" or "for example" in the embodiments of the present disclosure should not be construed as being more optional or advantageous than other embodiments or design solutions. To be precise, terms such as "exemplary" or "for example" are used to present related concepts in a specific manner.

The technologies described herein are not limited to a long term evolution (Long Time Evolution, LTE)/LTE-advanced (/LTE-Advanced, LTE-A) system, and may be used in various radio communication systems, such as code division multiple access (Code Division Multiple Access, CDMA), time division multiple access (Time Division Multiple Access, TDMA), frequency division multiple access (Frequency Division Multiple Access, FDMA), orthogonal frequency division multiple access (Orthogonal Frequency Division Multiple Access, OFDMA), single-carrier frequency-division multiple access (Single-carrier Frequency-Division Multiple Access, SC-FDMA) and other systems. The terms "system" and "network" are often used interchangeably. The CDMA system may implement radio technologies such as CDMA2000 and universal terrestrial radio access (Universal Terrestrial Radio Access, UTRA). UTRA includes wideband code division multiple access (Wideband Code Division Multiple Access, WCDMA) and other CDMA variants. The TDMA system may implement radio technologies such as global system for mobile communication (Global System for Mobile Communication, GSM). OFDMA system may implement radio technologies such as ultra mobile broadband (Ultra Mobile Broadband, UMB), evolution-UTRA (Evolution-UTRA, E-UTRA), IEEE 802.11 (wireless fidelity (wireless fidelity, Wi-Fi)), IEEE 802.16 (WiMAX), IEEE 802.20, Flash-OFDM. UTRA and E-UTRA are part of universal mobile telecommunications system (Universal Mobile Telecommunications System, UMTS). LTE and more advanced LTE (such as LTE-A) are new UMTS versions that use E-UTRA. UTRA, E-UTRA, UMTS, LTE, LTE-A, and GSM are described in documents from an organization named "3rd Generation Partnership Project" (3rd Generation Partnership Project, 3GPP). CDMA2000 and UMB are described in documents from an organization named "3rd Generation Partnership Project 2" (3rd Generation Partnership Project 2, 3GPP2). The technologies described herein may be used in the systems and radio technologies mentioned above, as well as other systems and radio technologies.

To facilitate understanding of the embodiments of the present disclosure, the following technical points are introduced.

### (1) User equipment capability reporting and storage mechanism

In the related technologies, an existing mechanism in a long term evolution (Long Term Evolution, LTE) system is that, in a case that a base station does not have a capability of a user equipment, it may transmit a capability query message to the user equipment, and the user equipment may report a user equipment capability message to the base station after receiving the capability query message. The base station stores the message and forwards it to a mobility management entity (Mobility Management Entity, MME) for storage. When the user equipment moves to a coverage of another base station, the another base station first obtains the capability information of the user equipment from the MME. If obtained, the capability is subsequently used, if not obtained, a capability query message is transmitted to the user equipment. In the related technologies, for each user equipment, the MME may store two capacity containers, where one of the containers stores general user equipment capacities and the other of the containers stores a paging capacity of the user equipment.

### (2) The operating mechanism of data compression

Data compression is to compress data of a data radio bearer (Data Radio Bearer, DRB). In related technologies, there is no compression mechanism for a signaling radio bearer (Signaling Radio Bearer, SRB). Currently, a packet data convergence protocol (Packet Data Convergence Protocol, PDCP) layer has two compression mechanisms for a DRB, one is a header compression mechanism based on robust header compression (Robust Header Compression, ROHC), and the other is an uplink data compression (Uplink Data Compression, UDC) mechanism based on a dictionary.

### (3) Preset dictionary

In an LTE system in the related technologies, in the UDC mechanism for uplink data, there may be two types of preset dictionaries for UDC. One is dictionary(ies) used for session initiation protocol (Session Initiation Protocol, SIP) signaling compression, which is defined in the standardized RFC 3485. The other is dictionary(ies) defined by a carrier. The user equipment may only store dictionary(ies) defined by one carrier.

Embodiments of the present disclosure are described hereinafter in conjunction with the drawings. The data processing method and device according to the embodiments of the present disclosure may be applied to a radio communication system. The radio communication system may be a fifth-generation mobile communication technology (fifth-generation, 5G) system, or an evolved long term evolution (Evolved Long Term evolution, eLTE) system, or a subsequent evolved communication system.

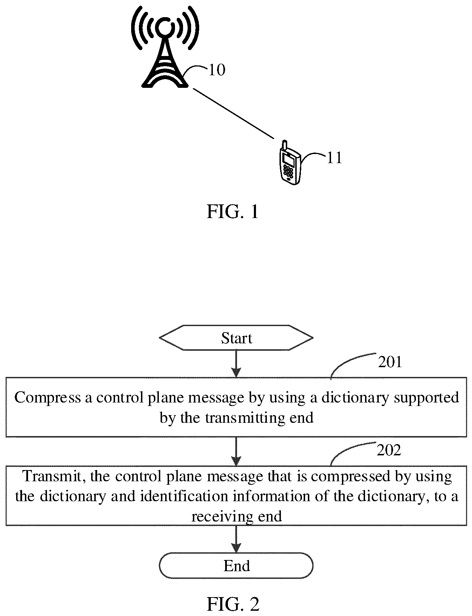

Reference is made to FIG. 1, which is a schematic diagram of an architecture of a radio communication system according to embodiments of the present disclosure. As shown in FIG. 1, the radio communication system may include: a network device 10 and a user equipment. The user equipment is denoted as UE 11, and the UE 11 may communicate with the network device 10 (to transmit signaling or transmit data). In practical applications, connection between the above various devices may be a wireless connection. In order to conveniently and intuitively indicate the connection relationship between the various devices, a solid line is shown in FIG. 1.

It should be noted that the above communication system may include multiple UEs 11, and the network device 10 may communicate with the multiple UEs 11.

It should be noted that the network device 10 in the above communication system may be a base station, and the base station may be a commonly used base station, or an evolved node base station (evolved node base station, eNB), or a network device in a 5G system (such as a next generation node base station (next generation node base station, gNB) or a transmission and reception point (transmission and reception point, TRP)) or other devices.

The UE 11 in the embodiments of the present disclosure may be a mobile phone, a tablet computer, a notebook computer, an ultra-mobile personal computer (Ultra-Mobile Personal Computer, UMPC), a netbook, or a personal digital assistant (Personal Digital Assistant, PDA), etc.

Referring to FIG. 2, embodiments of the present disclosure provide a method for transmitting a control plane message. The executive body of the method is a transmitting end, and the transmitting end may be a user equipment or a network device. The specific steps are as follows.

Step 201 includes: compressing a control plane message by using a dictionary supported by the transmitting end.

In the embodiments of the present disclosure, since different transmitting ends support different capabilities, the different transmitting ends support different dictionaries. Therefore, when compressing the control plane message, the dictionary supported by the transmitting end needs to be used.

Optionally, before compressing the control plane message by using the dictionary supported by the transmitting end, only dictionary(ies) supported by the transmitting end are stored in the transmitting end, or, all dictionaries existing in a network are stored in the transmitting end, to save storage resources.

Reference is made to Table 1, which is an example of the correspondence between user equipments and dictionaries provided by embodiments of the present disclosure. The dictionaries supported by the user equipments of various models have the same parts and have different parts.

**Table 1**

| User equipment | Dictionaries |
|---|---|
| A1 | S1+S2+S4+S6 |
| A2 | S1+S2+S5+S7 |
| A3 | S1+S2+S8 |
| B1 | S1+S3+S4+S9 |
| B2 | S1+S3+S5+S10 |

In the network, there are 3 different types of user equipments, A1, A2, and A3, produced by the user equipment manufacturer; and 2 different types of user equipments, B1 and B2, produced by the user equipment manufacturer B. In the user equipment capability, part of the user equipment capability which is supported by A1, A2, A3, B1 and B2, i.e., the supported dictionary, is S1; part of the user equipment capability which is only supported by A1, A2 and A3, i.e., the supported dictionary, is S2; part of the user equipment capability which is only supported by B1 and B2, i.e., the supported dictionary, is S3; part of the user equipment capability which is only supported by A1 and B1, i.e., the supported dictionary, is S4; part of the user equipment capability which is only supported by A2 and B2, i.e., the supported dictionary, is S5; part of the user equipment capability which is only supported by A1, i.e., the supported dictionary, is S6; part of the user equipment capability which is only supported by A2, i.e., the supported dictionary, is S7; part of the user equipment capability which is only supported by A3, i.e., the supported dictionary, is S8; part of the user equipment capability which is only supported by B1, i.e., the supported dictionary, is S9; part of the user equipment capability which is only supported by B2, i.e., the supported dictionary, is S10. Then the dictionaries stored in A1 include S1+S2+S4+S6, and the dictionaries stored in A2 include S 1+S2+S5+S7, and so on.

It can be understood that since the user equipment needs to transmit the compressed control plane message to the network device, the network device needs to support the dictionaries of all types of user equipments, that is, the dictionaries stored by the network device include S1+S2+S3+S4+S5+S6+ S7+S8+S9+S10.

Reference is made to Table 2, which is another example of the correspondence between user equipments and dictionaries provided by the embodiments of the present disclosure. The dictionaries supported by the user equipments of various models are different.

**Table 2**

| User equipment | Dictionary |
|---|---|
| A1 | S1 |
| A2 | S2 |
| A3 | S3 |
| B1 | S4 |
| B2 | S5 |

In the network, there are 3 different types of user equipments, A1, A2, and A3, produced by the user equipment manufacturer A; and 2 different types of user equipments, B1 and B2, produced by the user equipment manufacturer B. The dictionary supported by user equipment A1 is S1, the dictionary supported by user equipment A2 is S2, the dictionary supported by user equipment A3 is S3, the dictionary supported by user equipment B1 is S4, and the dictionary supported by user equipment B2 is S2. Correspondingly, the dictionary stored in the user equipment A1 is S1, the dictionary stored in the user equipment A2 is S2, and so on, and the dictionaries of the network device include S 1+S2+S3+S4.

It should be noted that the correspondences between the user equipment models and the stored dictionaries in Table 1 and Table 2 are only examples, and the correspondence between the user equipment models and the stored dictionaries is not specifically limited in the embodiments of the present disclosure.

Further, Table 2 is taken as an example. In a case that the user equipment A1 produced by the user equipment manufacturer A has undergone a software version upgrade, the dictionary supported by the new version of A1 is S5, the user equipment manufacturer B has newly released a new user equipment B3, and the dictionary supported by B3 is S6, then the base station updates the stored dictionaries to S1+S2+S3+S4+S5+S6. The dictionary stored in the user equipment A1 of the upgraded version is S5, and the dictionary stored in the user equipment A1 of the non-upgraded version is S1. The dictionary stored in B3 is S6.

Step 202 includes: transmitting, the control plane message that is compressed by using the dictionary and identification information of the dictionary, to a receiving end.

In the embodiments of the present disclosure, the identification information of the dictionary is used to indicate which dictionary is used for compressing of the control plane information. For example, in Table 2, the user equipment A1 uses the dictionary S1 to compress the control plane message, and the identification information of the corresponding dictionary is S1.

Optionally, the identification information of the dictionary is included in a PDCP header.

Optionally, the identification information of the dictionary is included in a radio resource control (Radio Resource Control, RRC) message.

Further, the transmitting end transmits the compressed control plane message and the identification information of the dictionary to the receiving end through a dedicated signaling bearer (such as SRB4).

Further, before transmitting the control plane message that is compressed by using the dictionary and the identification information of the dictionary to the receiving end through the dedicated signaling bearer, the method further includes: obtaining the dedicated signaling bearer configured by the receiving end, or, configuring the dedicated signaling bearer for the receiving end.

In the embodiments of the present disclosure, the transmitting end uses the dictionary supported by the transmitting end to compress the control plane information, and transmits the control plane message compressed using the dictionary and the identification information of the dictionary to the receiving end, and the receiving end determines the corresponding dictionary based on the identification information of the dictionary, and decompresses the compressed control plane message based on the dictionary to obtain the control plane message, which realizes transmission of relatively large (for example, exceeding the maximum length of the PDCP PDU) control plane information, and reduces signaling load between the transmitting end and the receiving end.

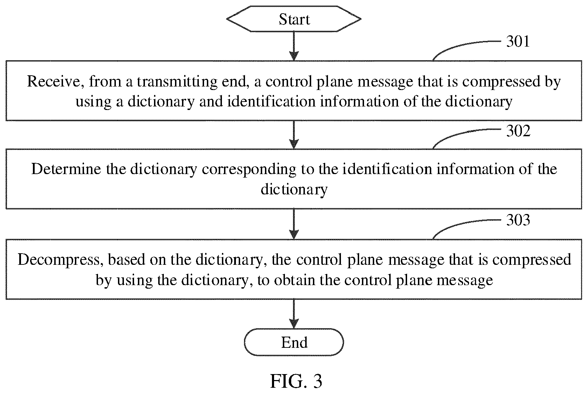

Referring to FIG. 3, embodiments of the present disclosure provide a method for receiving a control plane message. The executive body of the method is a receiving end, and the receiving end may be a network device or a user equipment. The specific steps are as follows.

Step 301 includes: receiving, from a transmitting end, a control plane message that is compressed by using a dictionary and identification information of the dictionary.

In embodiments of the present disclosure, optionally, before receiving from the transmitting end the control plane message that is compressed by using the dictionary and the identification information of the dictionary, only dictionaries supported by the receiving end are stored in the receiving end, or, all dictionaries existing in a network are stored in the receiving end, to enable the network device to decompress the control plane messages compressed by all user equipments.

Optionally, the identification information of the dictionary is included in a PDCP header.

Optionally, the identification information of the dictionary is included in an RRC message.

Further, the control plane message that is compressed by using the dictionary and the identification information of the dictionary are received from the transmitting end through a dedicated signaling bearer.

Further, before receiving, through the dedicated signaling bearer, from the transmitting end, the control plane message that is compressed by using the dictionary and the identification information of the dictionary, the method further includes: configuring the dedicated signaling bearer for the transmitting end, or, obtaining the dedicated signaling bearer configured by the transmitting end.

Step 302 includes: determining the dictionary corresponding to the identification information of the dictionary.

In the embodiments of the present disclosures, the dictionary used by the transmitting end when compressing the control plane message is determined based on the identification information of the dictionary.

Step 303 includes: decompressing, based on the dictionary, the control plane message that is compressed by using the dictionary, to obtain the control plane message.

In the embodiments of the present disclosure, after the dictionary corresponding to the identification information of the dictionary is determined, the determined dictionary is used to decompress the control plane message.

In the embodiments of the present disclosure, the receiving end determines the corresponding dictionary based on the identification information of the dictionary, and decompresses the compressed control plane message based on the dictionary to obtain the control plane message, which realizes transmission of relatively large (such as exceeding the maximum length of the PDCP PDU) control plane information, and reduces signaling load between the transmitting end and the receiving end.

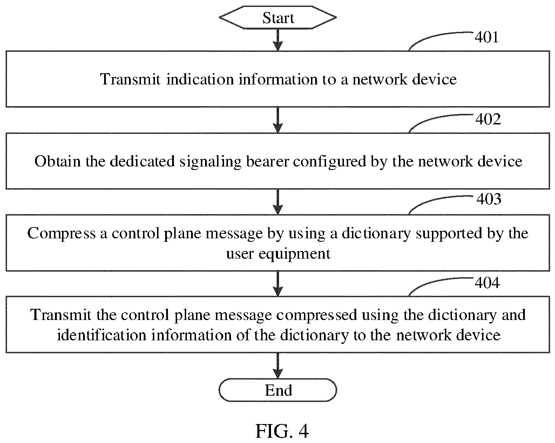

Referring to Fig. 4, embodiments of the present disclosure provide another method for transmitting a control plane message. The executive body of the method is a user equipment. The specific steps are as follows.

Step 401 includes: transmitting indication information to a network device.

In the embodiments of the present disclosure, the indication information is used to indicate that the user equipment supports using a dedicated signaling bear to transmit compressed signaling.

Step 402 includes: obtaining the dedicated signaling bearer configured by the network device.

In the embodiments of the present disclosure, the dedicated signaling bearer (such as SRB4) is configured by the network device for the user equipment based on the indication information.

Step 403 includes: compressing a control plane message by using a dictionary supported by the user equipment.

Step 404 includes: transmitting the control plane message compressed using the dictionary and identification information of the dictionary to the network device.

For the above step 403 and step 404, reference may be made to the descriptions of step 201 and step 202 in FIG. 2, which are not further described herein.

In the embodiments of the present disclosure, the user equipment transmits to the network device the indication information for indicating that the user equipment supports using the dedicated signaling bear to transmit the compressed signaling, obtains the dedicated signaling bearer configured by the network device, and transmits the compressed control plane message and the identification information of the dictionary through the dedicated signaling bear after compressing the control plane message, which realizes transmission of relatively large (such as exceeding the maximum length of the PDCP PDU) control plane information, and reduces signaling load between the user equipment and the network device.

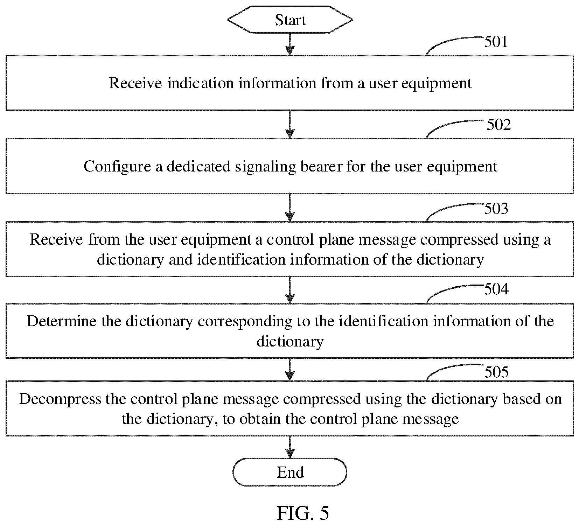

Referring to FIG. 5, embodiments of the present disclosure provide another method for receiving a control plane message. The executive body of the method is a network device. The specific steps are as follows.

Step 501 includes: receiving indication information from a user equipment.

In the embodiments of the present disclosure, the indication information is used to indicate that the user equipment supports using a dedicated signaling bear to transmit compressed signaling.

Step 502 includes: configuring a dedicated signaling bearer for the user equipment.

In the embodiments of the present disclosure, the network device configures the dedicated signaling bearer (such as SRB4) for the user equipment based on the indication information.

Step 503 includes: receiving from the user equipment a control plane message compressed using a dictionary and identification information of the dictionary.

Step 504 includes: determining the dictionary corresponding to the identification information of the dictionary.

Step 505 includes: decompressing the control plane message compressed using the dictionary based on the dictionary, to obtain the control plane message.

For the above steps 501 to 503, reference may be made to the descriptions of step 301 to step 303 in FIG. 3, which are not further described herein.

In the embodiments of the present disclosure, the network device configures the dedicated signaling bearer for the user equipment based on the indication information transmitted by the user equipment for indicating that the user equipment supports using the dedicated signaling bear to transmit the compressed signaling, determines the corresponding dictionary based on the identification information of the dictionary after receiving from the user equipment the control plane message compressed using the dictionary and the identification information of the dictionary, and decompresses the compressed control plane message based on the dictionary, to obtain the control plane message, which realizes transmission of relatively large (for example, exceeding the maximum length of the PDCP PDU) control plane information, and reduces signaling load between the user equipment and the network device.

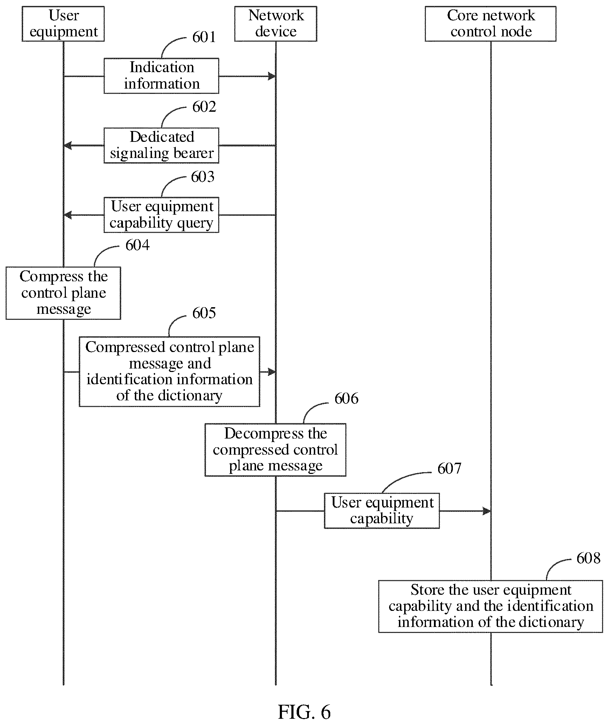

Referring to FIG. 6, embodiments of the present disclosure provide a transmission method for a control plane message. The specific process is as follows.

In step 601, a user equipment transmits indication information to a network device.

In the embodiments of the present disclosure, the indication information is used to indicate that the user equipment supports using a dedicated signaling bear to transmit compressed signaling.

In step 602, the network device configures the dedicated signaling bearer for the user equipment.

In the embodiments of the present disclosure, optionally, the dedicated signaling bearer is SRB4.

In step 603, the network device transmits a user equipment capability query message to the user equipment.

In step 604, the user equipment compresses a control plane message.

In the embodiments of the present disclosure, the user equipment uses a dictionary supported by the user equipment to compress the control plane message, to obtain the compressed control plane message.

In step 605, the user equipment transmits the control plane message compressed using the dictionary and identification information of the dictionary to the network device.

In the embodiments of the present disclosure, when transmitting the control plane message compressed using the dictionary to the network device through the dedicated signaling bearer, the user equipment also transmits the identification information of the dictionary to the network device.

In step 606, the network device decompresses the compressed control plane message.

In the embodiments of the present disclosure, the network device determines the dictionary used for decompression based on the identification information of the dictionary, and uses the dictionary to decompress the compressed control plane message to obtain the control plane message, i.e., a user equipment capability.

In step 607, the network device transmits the user equipment capability to a core network control node.

In the embodiments of the present disclosure, when transmitting the user equipment capability, the network device also transmits the identification information of the dictionary to the core network control node.

In step 608, the core network control node stores the user equipment capability and the identification information of the dictionary.

In the embodiments of the present disclosure, the user equipment uses the dictionary supported by the user equipment to compress the control plane information, and then transmits the control plane message compressed using the dictionary and the identification information of the dictionary to the network device, and the network device determines the corresponding dictionary based on the identification information of the dictionary, and uses the dictionary to decompress the compressed control plane message to obtain the control plane message, which realizes transmission of relatively large (for example, exceeding the maximum length of the PDCP PDU) control plane information, and reduces signaling load between the user equipment and the network device.

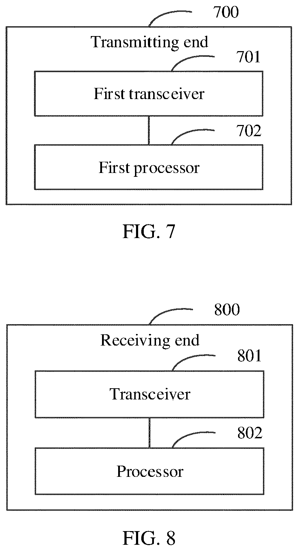

Referring to FIG. 7, embodiments of the present disclosure provide a transmitting end 700, including: a first transceiver 701 and a first processor 702.

The first processor 702 is configured to compress a control plane message by using a dictionary supported by the transmitting end.

The first transceiver 701 is configured to transmit, the control plane message that is compressed by using the dictionary and identification information of the dictionary, to a receiving end.

Optionally, the identification information of the dictionary is included in a packet data convergence protocol (PDCP) header.

Optionally, the identification information of the dictionary is included in an RRC message.

Optionally, the first transceiver 701 is further configured transmit the control plane message that is compressed by using the dictionary and the identification information of the dictionary to the receiving end through a dedicated signaling bearer.

Optionally, the first transceiver 701 is further configured to obtain the dedicated signaling bearer configured by the receiving end, or, configuring the dedicated signaling bearer for the receiving end.

Optionally, the first processor 702 is further configured to store only dictionaries supported by the transmitting end in the transmitting end, or, store all dictionaries existing in a network in the transmitting end.

In the embodiments of the present disclosure, the receiving end determines the corresponding dictionary based on the identification information of the dictionary, and decompresses the compressed control plane message based on the dictionary to obtain the control plane message, which realizes transmission of relatively large (for example, exceeding the maximum length of the PDCP PDU) control plane information, and reduces signaling load between the transmitting end and the receiving end.

Referring to FIG. 8, embodiments of the present disclosure provide a receiving end 800, including: a second transceiver 801 and a second processor 802.

The second transceiver 801 is configured to receive, from a transmitting end, a control plane message that is compressed by using a dictionary and identification information of the dictionary.

The second processor 802 is configured to determine the dictionary corresponding to the identification information of the dictionary.

The second processor 802 is further configured to decompress, based on the dictionary, the control plane message that is compressed by using the dictionary, to obtain the control plane message.

Optionally, the identification information of the dictionary is included in a PDCP header.

Optionally, the identification information of the dictionary is included in an RRC message.

Optionally, the second transceiver 801 is further configured to receive, through a dedicated signaling bearer, from the transmitting end, the control plane message that is compressed by using the dictionary and the identification information of the dictionary.

Optionally, the second transceiver 801 is further configured to configure the dedicated signaling bearer for the transmitting end, or, obtain the dedicated signaling bearer configured by the transmitting end.

Optionally, the second processor 802 is further configured to store only dictionaries supported by the receiving end in the receiving end, or, store all dictionaries existing in a network in the receiving end.

In the embodiments of the present disclosure, the transmitting end uses the dictionary supported by the transmitting end to compress the control plane information, and transmits the control plane message compressed using the dictionary and the identification information of the dictionary to the receiving end, and the receiving end determines the corresponding dictionary based on the identification information of the dictionary, and decompresses the compressed control plane message based on the dictionary to obtain the control plane message, which realizes transmission of relatively large (for example, exceeding the maximum length of the PDCP PDU) control plane information, and reduces signaling load between the transmitting end and the receiving end.

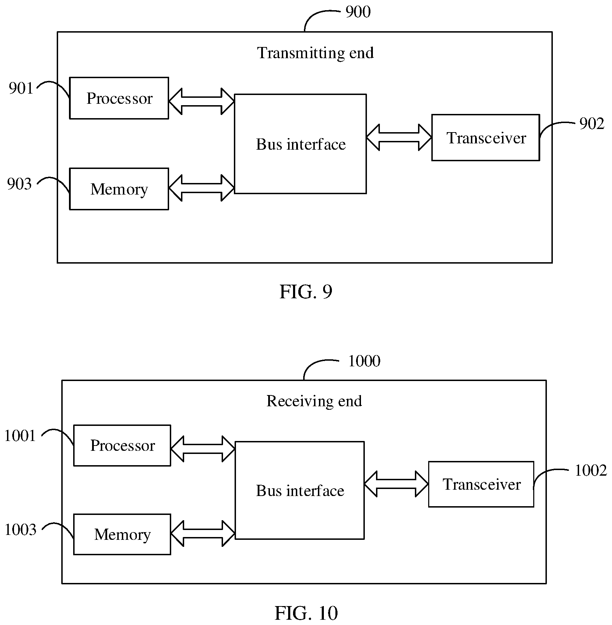

Referring to FIG. 9, embodiments of the present disclosure provide another transmitting end 900, which includes a processor 901, a transceiver 902, a memory 903, and a bus interface.

The processor 901 may be responsible for managing the bus architecture and common processing. The memory 903 may store data used by the processor 901 when performing operations.

In embodiments of the present disclosure, the transmitting end 900 may further include: a program stored in the memory 903 and executable by the processor 901. The program, when being executed by the processor, performs the following steps: compressing a control plane message by using a dictionary supported by the transmitting end; and transmitting, the control plane message that is compressed by using the dictionary and identification information of the dictionary, to a receiving end.

Optionally, the identification information of the dictionary is included in a packet data convergence protocol (PDCP) header.

Optionally, the identification information of the dictionary is included in an RRC message.

Optionally, the program, when being executed by the processor, performs the following steps: transmitting the control plane message that is compressed by using the dictionary and the identification information of the dictionary to the receiving end through a dedicated signaling bearer.

Optionally, the program, when being executed by the processor, performs the following steps: obtaining the dedicated signaling bearer configured by the receiving end, or, configuring the dedicated signaling bearer for the receiving end.

Optionally, the program, when being executed by the processor, performs the following steps: storing only dictionaries supported by the transmitting end in the transmitting end, or, storing all dictionaries existing in a network in the transmitting end.

In FIG. 9, the bus architecture may include any quantity of interconnected buses and bridges. Specifically, various circuits of one or more processors represented by the processor 901 and a memory represented by the memory 903 are coupled together. The bus architecture may also couple various other circuits such as a peripheral device, a voltage regulator, and a power management circuit, etc., which are known in the art, and are not further described in the embodiments of the present disclosure. The bus interface provides an interface. The transceiver 902 may be multiple elements, i.e., including a transmitter and a receiver, for providing a unit configured to communicate with various other devices on a transmission medium.

In the embodiments of the present disclosure, the transmitting end uses the dictionary supported by the transmitting end to compress the control plane information, and transmits the control plane message compressed using the dictionary and the identification information of the dictionary to the receiving end, and the receiving end determines the corresponding dictionary based on the identification information of the dictionary, and decompresses the compressed control plane message based on the dictionary to obtain the control plane message, which realizes transmission of relatively large (for example, exceeding the maximum length of the PDCP PDU) control plane information, and reduces signaling load between the transmitting end and the receiving end.

Referring to FIG. 10, embodiments of the present disclosure provide another receiving end 1000, which includes a processor 1001, a transceiver 1002, a memory 1003, and a bus interface.

The processor 1001 may be responsible for managing the bus architecture and common processing. The memory 1003 may store data used by the processor 1001 when performing operations.

In the embodiments of the present disclosure, the receiving end 1000 may further include: a program stored in the memory 1003 and executable by the processor 1001. The program, when being executed by the processor 1001, performs the following steps: receiving, from a transmitting end, a control plane message that is compressed by using a dictionary and identification information of the dictionary; determining the dictionary corresponding to the identification information of the dictionary; and decompressing, based on the dictionary, the control plane message that is compressed by using the dictionary, to obtain the control plane message.

Optionally, the identification information of the dictionary is included in a PDCP header.

Optionally, the identification information of the dictionary is included in an RRC message.

Optionally, the program, when being executed by the processor, performs the following steps: receiving, through a dedicated signaling bearer, from the transmitting end, the control plane message that is compressed by using the dictionary and the identification information of the dictionary.

Optionally, the program, when being executed by the processor, performs the following steps: configuring the dedicated signaling bearer for the transmitting end, or, obtaining the dedicated signaling bearer configured by the transmitting end.

Optionally, the program, when being executed by the processor, performs the following steps: storing only dictionaries supported by the receiving end in the receiving end, or, storing all dictionaries existing in a network in the receiving end.

In FIG. 10, the bus architecture may include any quantity of interconnected buses and bridges. Specifically, various circuits of one or more processors represented by the processor 1001 and a memory represented by the memory 1003 are coupled together. The bus architecture may also couple various other circuits such as a peripheral device, a voltage regulator, and a power management circuit, etc., which are known in the art, and are not further described in the embodiments of the present disclosure. The bus interface provides an interface. The transceiver 1002 may be multiple elements, i.e., including a transmitter and a receiver, for providing a unit configured to communicate with various other devices on a transmission medium.

In the embodiments of the present disclosure, the transmitting end uses the dictionary supported by the transmitting end to compress the control plane information, and transmits the control plane message compressed using the dictionary and the identification information of the dictionary to the receiving end, and the receiving end determines the corresponding dictionary based on the identification information of the dictionary, and decompresses the compressed control plane message based on the dictionary to obtain the control plane message, which realizes transmission of relatively large (for example, exceeding the maximum length of the PDCP PDU) control plane information, and reduces signaling load between the transmitting end and the receiving end.

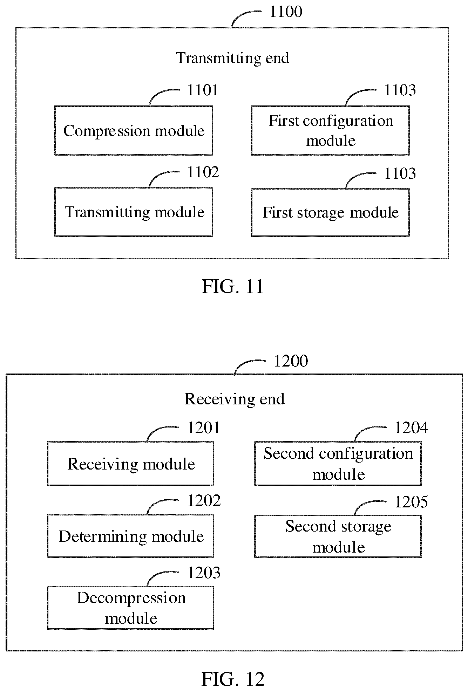

Referring to FIG. 11, embodiments of the present disclosure provide a transmitting end 1100, including:
a compression module 1101, configured to compress a control plane message by using a dictionary supported by the transmitting end; and
a transmitting module 1102, configured to transmit, to a receiving end, the control plane message that is compressed by using the dictionary and identification information of the dictionary.

Optionally, the identification information of the dictionary is included in a PDCP header.

Optionally, the identification information of the dictionary is included in an RRC message.

Optionally, the transmitting module 1102 is specifically configured to transmit the control plane message that is compressed by using the dictionary and the identification information of the dictionary to the receiving end through a dedicated signaling bearer.

Optionally, the transmitting end 1100 further includes:
a first configuration module 1103, configured to obtain the dedicated signaling bearer configured by the receiving end, or, configure the dedicated signaling bearer for the receiving end.

Optionally, the transmitting end 1100 further includes:
a first storage module 1104, configured to store only dictionaries supported by the transmitting end in the transmitting end, or, store all dictionaries existing in a network in the transmitting end.

In the embodiments of the present disclosure, the transmitting end uses the dictionary supported by the transmitting end to compress the control plane information, and transmits the control plane message compressed using the dictionary and the identification information of the dictionary to the receiving end, and the receiving end determines the corresponding dictionary based on the identification information of the dictionary, and decompresses the compressed control plane message based on the dictionary to obtain the control plane message, which realizes transmission of relatively large (for example, exceeding the maximum length of the PDCP PDU) control plane information, and reduces signaling load between the transmitting end and the receiving end.

Referring to FIG. 12, embodiments of the present disclosure provide a receiving end 1200, including:
a receiving module 1201, configured to receive, from a transmitting end, a control plane message that is compressed by using a dictionary and identification information of the dictionary;
a determining module 1202, configured to determine the dictionary corresponding to the identification information of the dictionary; and
a decompression module 1203, configured to decompress, based on the dictionary, the control plane message that is compressed by using the dictionary, to obtain the control plane message.

Optionally, the identification information of the dictionary is included in a PDCP header.

Optionally, the identification information of the dictionary is included in an RRC message.

Optionally, the receiving module 1201 is specifically configured to receive, through a dedicated signaling bearer, from the transmitting end, the control plane message that is compressed by using the dictionary and the identification information of the dictionary.

Optionally, the receiving end 1200 further includes:
a second configuration module 1204, configured to configure the dedicated signaling bearer for the transmitting end, or, obtain the dedicated signaling bearer configured by the transmitting end.

Optionally, the receiving end 1200 further includes:
a second storage module 1205, configured to store only dictionaries supported by the receiving end in the receiving end, or, store all dictionaries existing in a network in the receiving end.

In the embodiments of the present disclosure, the receiving end determines the corresponding dictionary based on the identification information of the dictionary, and decompresses the compressed control plane message based on the dictionary to obtain the control plane message, which realizes transmission of relatively large (for example, exceeding the maximum length of the PDCP PDU) control plane information, and reduces signaling load between the transmitting end and the receiving end.

The embodiments of the present disclosure also provide a computer readable storage medium, where a computer program is stored in the computer readable storage medium. The computer program, when being executed by a processor, performs the various processes of the embodiments of the above method for network access, and the same technical effects can be achieved, which are not further described herein to avoid repetition. The computer readable storage medium may be, for example, a read-only memory (Read-Only Memory, ROM), a random access memory (Random Access Memory, RAM), a magnetic disk, or an optical disk, etc.

The steps of the method or algorithm described in connection with the disclosed content of the present disclosure may be implemented in a hardware manner, or may be implemented in a manner where a processor executes software instructions. The software instructions may be formed by corresponding software modules. The software modules may be stored in an RAM, a flash memory, an ROM, an electrically programmable read-only memory (Electrically Programmable Read-Only-Memory, EPROM), an electrically erasable programmable read-only memory (Electrically Erasable Programmable Read-Only-Memory, EEPROM), a register, a hard disk, a mobile hard disk, a CD-ROM or any other form of storage medium known in the art. An exemplary storage medium is coupled to a processor, so that the processor may read information from the storage medium and may write information to the storage medium. Or, the storage medium may be an integral part of the processor. The processor and the storage medium may be located in an ASIC. In addition, the ASIC may be located in a core network interface device. Or, the processor and the storage medium may exist as discrete components in the core network interface device.

Those skilled in the art should be aware that, in one or more of the above examples, the functions described in the present disclosure may be implemented by hardware, software, firmware, or any combination thereof. When implemented by software, these functions may be stored in a computer readable medium or transmitted as one or more instructions or codes on the computer readable medium. The computer readable medium includes a computer storage medium and a communication medium, where the communication medium includes any medium that facilitates the transfer of a computer program from one place to another. The storage medium may be any available medium that can be accessed by a general-purpose or special-purpose computer.

The above specific embodiments further describe the objects, technical solutions, and beneficial effects of the present disclosure in detail. It should be understood that the above descriptions are only specific embodiments of the present disclosure and are not intended to limit the protection scope of the present disclosure.

Those skilled in the art should understand that the embodiments of the present disclosure may be provided as methods, systems, or computer program products. Therefore, the embodiments of the present disclosure may adopt the form of a complete hardware embodiment, a complete software embodiment, or an embodiment combining software and hardware. Moreover, the embodiments of the present disclosure may use the form of a computer program product implemented on one or more computer-usable storage media (including but not limited to a disk storage, a compact disc read-only-memory (Compact Disc Read-Only-Memory, CD-ROM), or an optical storage, etc.) containing computer-usable program codes.

The embodiments of the present disclosure are described with reference to flowcharts and/or block diagrams of methods, devices (systems), and computer program products according to the embodiments of the present disclosure. It should be understood that each process and/or block in the flowchart and/or block diagram, and the combination of processes and/or blocks in the flowchart and/or block diagram may be implemented by computer program instructions. These computer program instructions may be provided to a general-purpose computer, a special-purpose computer, an embedded processor, or a processor of other programmable data processing device to generate a machine, so that a device, which is configured to implement functions specified in one process or multiple processes in the flowchart and/or one block or multiple blocks in the block diagram, is generated through the instructions executed by the computer or the processor of other programmable data processing device.

These computer program instructions may be stored in a computer readable memory that may guide a computer or other programmable data processing device to operate in a specific manner, so that the instructions stored in the computer readable memory generate a product including an instruction device. The instruction device implements the functions specified in one process or multiple processes in the flowchart and/or one block or multiple blocks in the block diagram.

These computer program instructions may be loaded in a computer or other programmable data processing device, to enable a series of operation steps to be executed on the computer or other programmable equipment to realize computer-implemented processing, so that the instructions executed on the computer or other programmable device provide steps for implementing functions specified in a process or multiple processes in the flowchart and/or a block or multiple blocks in the block diagram.

It can be understood that the embodiments described in the present disclosure may be implemented by hardware, software, firmware, middleware, microcode, or a combination thereof. For hardware implementation, the processing unit may be implemented in one or more application specific integrated circuits (Application Specific Integrated Circuits, ASIC), digital signal processors (Digital Signal Processing, DSP), digital signal processing devices (DSP Device, DSPD), programmable logic devices (Programmable Logic Device, PLD), field-programmable gate arrays (Field-Programmable Gate Array, FPGA), general-purpose processors, controllers, microcontrollers, microprocessors, others electronic units for performing the functions described in the present disclosure, or a combination thereof.

For software implementation, the technologies described in the embodiments of the present disclosure may be implemented by modules (such as processes, functions, etc.) that perform the functions described in the embodiments of the present disclosure. Software codes may be stored in a memory and executed by a processor. The memory may be implemented in the processor or external to the processor.

## Claims

1. A method for transmitting a control plane message, applied to a transmitting end, comprising:
compressing (201) a control plane message by using a dictionary supported by the transmitting end; and
transmitting (202), to a receiving end, the control plane message that is compressed by using the dictionary and identification information of the dictionary, wherein the identification information is transmitted together with the control plane message that is compressed;
wherein the transmitting (202), to the receiving end, the control plane message that is compressed by using the dictionary and the identification information of the dictionary comprises: transmitting the control plane message that is compressed by using the dictionary and the identification information of the dictionary to the receiving end through a dedicated signaling bearer;
wherein before the transmitting the control plane message that is compressed by using the dictionary and the identification information of the dictionary to the receiving end through the dedicated signaling bearer, the method further comprises: obtaining the dedicated signaling bearer configured by the receiving end, or, configuring the dedicated signaling bearer for the receiving end.

2. The method according to claim 1, wherein the identification information of the dictionary is comprised in a packet data convergence protocol (PDCP) header.

3. The method according to claim 1, wherein the identification information of the dictionary is comprised in a radio resource control (RRC) message.

4. The method according to claim 1, wherein before the compressing (201) the control plane message by using the dictionary supported by the transmitting end, the method further comprises:
storing, in the transmitting end, only dictionaries supported by the transmitting end, or, storing, in the transmitting end, all dictionaries existing in a network.

5. The method according to claim 1, wherein in a case that the transmitting end is a user equipment and the receiving end is a network device, before the transmitting the control plane message that is compressed by using the dictionary and the identification information of the dictionary to the receiving end through the dedicated signaling bearer, the method further comprises:
transmitting (401) indication information to the network device, and obtaining (402) the dedicated signaling bearer configured by the network device, wherein the indication information is used to indicate that the user equipment supports using the dedicated signaling bear to transmit compressed signaling; or,
wherein in a case that the transmitting end is a network device and the receiving end is a user equipment, before the transmitting the control plane message that is compressed by using the dictionary and the identification information of the dictionary to the receiving end through the dedicated signaling bearer, the method further comprises:
receiving (501) indication information from the user equipment, and configuring (502) the dedicated signaling bearer for the user equipment, wherein the indication information is used to indicate that the user equipment supports using the dedicated signaling bear to transmit compressed signaling.

6. A method for receiving a control plane message, applied to a receiving end, comprising:
receiving (301), from a transmitting end, a control plane message that is compressed by using a dictionary and identification information of the dictionary, wherein the identification information is transmitted together with the control plane message that is compressed;
determining (302) the dictionary corresponding to the identification information of the dictionary; and
decompressing (303), based on the dictionary, the control plane message that is compressed by using the dictionary, to obtain the control plane message;
wherein the receiving (301), from the transmitting end, the control plane message that is compressed by using the dictionary and the identification information of the dictionary comprises: receiving, through a dedicated signaling bearer, from the transmitting end, the control plane message that is compressed by using the dictionary and the identification information of the dictionary;
wherein before the receiving, through the dedicated signaling bearer, from the transmitting end, the control plane message that is compressed by using the dictionary and the identification information of the dictionary, the method further comprises: configuring the dedicated signaling bearer for the transmitting end, or, obtaining the dedicated signaling bearer configured by the transmitting end.

7. The method according to claim 6, wherein the identification information of the dictionary is comprised in a packet data convergence protocol (PDCP) header; or,
the identification information of the dictionary is comprised in a radio resource control (RRC) message.

8. The method according to claim 6, wherein before the receiving (301), from the transmitting end, the control plane message that is compressed by using the dictionary and the identification information of the dictionary, the method further comprises: storing, in the receiving end, only dictionaries supported by the receiving end, or, storing, in the receiving end, all dictionaries existing in a network.

9. A transmitting end (1100), comprising:
a compression module (1101), configured to compress a control plane message by using a dictionary supported by the transmitting end (1100); and
a transmitting module (1102), configured to transmit, to a receiving end, the control plane message that is compressed by using the dictionary and identification information of the dictionary, wherein the identification information is transmitted together with the control plane message that is compressed;
wherein the transmitting module (1102) is configured to transmit the control plane message that is compressed by using the dictionary and the identification information of the dictionary to the receiving end through a dedicated signaling bearer;
wherein the transmitting end (1100) further comprises: a first configuration module, configured to obtain the dedicated signaling bearer configured by the receiving end, or, configure the dedicated signaling bearer for the receiving end.

10. The transmitting end (1100) according to claim 9, wherein the identification information of the dictionary is comprised in a packet data convergence protocol (PDCP) header.

11. The transmitting end (1100) according to claim 9, wherein the identification information of the dictionary is comprised in a radio resource control (RRC) message.

12. The transmitting end (1100) according to claim 9, further comprising:
a first storage module, configured to store only dictionaries supported by the transmitting end in the transmitting end, or, store all dictionaries existing in a network in the transmitting end.

13. A receiving end (1200), comprising:
a receiving module (1201), configured to receive, from a transmitting end, a control plane message that is compressed by using a dictionary and identification information of the dictionary, wherein the identification information is transmitted together with the control plane message that is compressed;
a determining module (1202), configured to determine the dictionary corresponding to the identification information of the dictionary; and
a decompression module (1203), configured to decompress, based on the dictionary, the control plane message that is compressed by using the dictionary, to obtain the control plane message;
wherein the receiving module (1201) is configured to receive, through a dedicated signaling bearer, from the transmitting end, the control plane message that is compressed by using the dictionary and the identification information of the dictionary;
wherein the receiving end (1200) further comprises: a second configuration module, configured to configure the dedicated signaling bearer for the transmitting end, or, obtain the dedicated signaling bearer configured by the transmitting end.

14. The receiving end (1200) according to claim 13, wherein the identification information of the dictionary is comprised in a packet data convergence protocol (PDCP) header; or,
the identification information of the dictionary is comprised in a radio resource control (RRC) message.

15. The receiving end (1200) according to claim 13, further comprising:
a second storage module, configured to store only dictionaries supported by the receiving end in the receiving end, or, store all dictionaries existing in a network in the receiving end.

## Patentansprüche

1. Verfahren zum Übertragen einer Steuerebenennachricht, angewandt auf ein Übertragungsende, umfassend:
Komprimieren (201) einer Steuerebenennachricht unter Verwendung eines von dem Übertragungsende unterstützten Wörterbuchs; und
Übertragen (202) der Steuerebenennachricht, die unter Verwendung des Wörterbuchs und der Identifikationsinformation des Wörterbuchs komprimiert ist, an ein Empfangsende, wobei die Identifikationsinformation zusammen mit der Steuerebenennachricht, die komprimiert ist, übertragen werden;
wobei das Übertragen (202) der Steuerebenennachricht, die unter Verwendung des Wörterbuchs und der Identifizierungsinformation des Wörterbuchs komprimiert ist, an das Empfangsende umfasst: Übertragen der Steuerebenennachricht, die unter Verwendung des Wörterbuchs und der Identifizierungsinformation des Wörterbuchs komprimiert ist, an das Empfangsende über einen dedizierten Signalisierungsträger;
wobei das Verfahren vor dem Übertragen der Steuerebenennachricht, die unter Verwendung des Wörterbuchs und der Identifizierungsinformation des Wörterbuchs komprimiert ist, über den dedizierten Signalisierungsträger an das Empfangsende ferner umfasst: Erhalten des dedizierten Signalisierungsträgers, der durch das Empfangsende konfiguriert ist, oder Konfigurieren des dedizierten Signalisierungsträgers für das Empfangsende.

2. Verfahren nach Anspruch 1, wobei die Identifikationsinformation des Wörterbuchs in einem Packet Data Convergence Protocol (PDCP) Header enthalten ist.

3. Verfahren nach Anspruch 1, wobei die Identifikationsinformation des Wörterbuchs in einer Radio Resource Control (RRC) Nachricht enthalten ist.

4. Verfahren nach Anspruch 1, wobei das Verfahren vor dem Komprimieren (201) der Steuerebenennachricht unter Verwendung des von dem Übertragungsende unterstützten Wörterbuchs ferner umfasst:
Speichern von nur von dem Übertragungsende unterstützten Wörterbüchern in dem Übertragungsende oder Speichern aller in einem Netzwerk vorhandenen Wörterbücher in dem Übertragungsende.

5. Verfahren nach Anspruch 1, wobei in einem Fall, in dem das Übertragungsende ein Benutzergerät und das Empfangsende eine Netzwerkvorrichtung ist, das Verfahren vor dem Übertragen der Steuerebenennachricht, die unter Verwendung des Wörterbuchs und der Identifizierungsinformation des Wörterbuchs komprimiert ist, über den dedizierten Signalisierungsträger an das Empfangsende ferner umfasst:
Übertragen (401) von Indikationsinformation an die Netzwerkvorrichtung und Erhalten (402) des von der Netzwerkvorrichtung konfigurierten dedizierten Signalträgers, wobei die Indikationsinformation verwendet wird, um anzugeben, dass das Benutzergerät die Verwendung des dedizierten Signalträgers zur Übertragung komprimierter Signale unterstützt; oder
wobei in einem Fall, in dem das Übertragungsende eine Netzwerkvorrichtung und das Empfangsende ein Benutzergerät ist, das Verfahren vor dem Übertragen der Steuerebenennachricht, die unter Verwendung des Wörterbuchs und der Identifizierungsinformation des Wörterbuchs komprimiert ist, über den dedizierten Signalisierungsträger an das Empfangsende ferner umfasst:
Empfangen (501) von Indikationsinformation von dem Benutzergerät und Konfigurieren (502) des dedizierten Signalisierungsträgers für das Benutzergerät, wobei die Indikationsinformation verwendet wird, um anzugeben, dass das Benutzergerät die Verwendung des dedizierten Signalisierungsträgers zur Übertragung komprimierter Signalisierung unterstützt.

6. Verfahren zum Empfangen einer Steuerebenennachricht, angewandt auf ein Empfangsende, umfassend:
Empfangen (301) einer Steuerebenennachricht, die unter Verwendung eines Wörterbuchs und von Identifizierungsinformation des Wörterbuchs komprimiert ist,
von einem Übertragungsende, wobei die Identifizierungsinformation zusammen mit der Steuerebenennachricht, die komprimiert ist, übertragen wird;
Bestimmen (302) des Wörterbuchs, das der Identifikationsinformation des Wörterbuchs entspricht; und
Dekomprimieren (303) der Steuerebenennachricht, die unter Verwendung des Wörterbuchs komprimiert wurde, auf der Grundlage des Wörterbuchs, um die Steuerebenennachricht zu erhalten;
wobei das Empfangen (301) der Steuerebenennachricht, die unter Verwendung des Wörterbuchs und der Identifizierungsinformation des Wörterbuchs komprimiert ist, vom Übertragungsende umfasst: Empfangen der Steuerebenennachricht, die unter Verwendung des Wörterbuchs und der Identifizierungsinformation des Wörterbuchs komprimiert ist, über einen dedizierten Signalisierungsträger vom Übertragungsende;
wobei das Verfahren vor dem Empfangen der Steuerebenennachricht, die unter Verwendung des Wörterbuchs und der Identifizierungsinformation des Wörterbuchs komprimiert ist, über den dedizierten Signalisierungsträger von dem Übertragungsende umfasst: Konfigurieren des dedizierten Signalisierungsträgers für das Übertragungsende oder Erhalten des dedizierten Signalisierungsträgers, der durch das Übertragungsende konfiguriert ist.

7. Verfahren nach Anspruch 6, wobei die Identifizierungsinformation des Wörterbuchs in einem Packet Data Convergence Protocol (PDCP) Header enthalten ist; oder,
die Identifizierungsinformation des Wörterbuchs in einer Radio Resource Control RRC) Nachricht enthalten ist.

8. Verfahren nach Anspruch 6, wobei das Verfahren vor dem Empfangen (301) der Steuerebenennachricht, die unter Verwendung des Wörterbuchs und der Identifizierungsinformation des Wörterbuchs komprimiert ist, von dem Übertragungsende ferner umfasst: Speichern nur von Wörterbüchern, die von dem Empfangsende unterstützt werden, in dem Empfangsende oder Speichern aller in einem Netzwerk vorhandenen Wörterbücher in dem Empfangsende.

9. Übertragungsende (1100), umfassend:
ein Kompressionsmodul (1101), das konfiguriert ist, um eine Steuerebenennachricht unter Verwendung eines von dem Übertragungsende (1100) unterstützten Wörterbuchs zu komprimieren; und
ein Übertragungsmodul (1102), das konfiguriert ist, um die Steuerebenennachricht, die unter Verwendung des Wörterbuchs und der Identifikationsinformation des Wörterbuchs komprimiert ist, an ein Empfangsende zu übertragen, wobei die Identifikationsinformation zusammen mit der Steuerebenennachricht, die komprimiert ist, übertragen wird;
wobei das Übertragungsmodul (1102) konfiguriert ist, um die Steuerebenennachricht, die unter Verwendung des Wörterbuchs und der Identifikationsinformation des Wörterbuchs komprimiert ist, über einen dedizierten Signalisierungsträger an das Empfangsende zu übertragen;
wobei das Übertragungsende (1100) ferner umfasst: ein erstes Konfigurationsmodul, das konfiguriert ist, um den vom Empfangsende konfigurierten dedizierten Signalisierungsträger zu erhalten oder den dedizierten Signalisierungsträger für das Empfangsende zu konfigurieren.

10. Übertragungsende (1100) nach Anspruch 9, wobei die Identifikationsinformation des Wörterbuchs in einem Packet Data Convergence Protocol (PDCP) Header enthalten ist.

11. Übertragungsende (1100) nach Anspruch 9, wobei die Identifikationsinformation des Wörterbuchs in einer Radio Resource Control (RRC) Nachricht enthalten ist.

12. Übertragungsende (1100) nach Anspruch 9, ferner umfassend:
ein erstes Speichermodul, das konfiguriert ist, um nur Wörterbücher, die von dem Übertragungsende unterstützt werden, in dem Übertragungsende zu speichern, oder alle in einem Netzwerk vorhandenen Wörterbücher in dem Übertragungsende zu speichern.

13. Empfangsende (1200), umfassend:
ein Empfangsmodul (1201), das konfiguriert ist, um von einem Übertragungsende eine Steuerebenennachricht zu empfangen, die unter Verwendung eines Wörterbuchs und
einer Identifikationsinformation des Wörterbuchs komprimiert ist, wobei die Identifikationsinformation zusammen mit der Steuerebenennachricht, die komprimiert ist, übertragen wird;
ein Bestimmungsmodul (1202), das konfiguriert ist, um das Wörterbuch entsprechend der Identifikationsinformation des Wörterbuchs zu bestimmen; und
ein Dekompressionsmodul (1203), das konfiguriert ist, um die Steuerebenennachricht, die unter Verwendung des Wörterbuchs komprimiert ist, auf der Grundlage des Wörterbuchs zu dekomprimieren, um die Steuerebenennachricht zu erhalten;
wobei das Empfangsmodul (1201) konfiguriert ist, um die Steuerebenennachricht, die unter Verwendung des Wörterbuchs und der Identifizierungsinformation des Wörterbuchs komprimiert ist, über einen dedizierten Signalisierungsträger vom Übertragungsende zu empfangen; wobei das Empfangsende (1200) ferner umfasst: ein zweites Konfigurationsmodul, das konfiguriert ist, um den dedizierten Signalisierungsträger für das Übertragungsende zu konfigurieren, oder den vom Übertragungsende konfigurierten dedizierten Signalisierungsträger zu erhalten.

14. Empfangsende (1200) nach Anspruch 13, wobei die Identifizierungsinformation des Wörterbuchs in einem Packet Data Convergence Protocol (PDCP) Header enthalten ist; oder,
die Identifizierungsinformation des Wörterbuchs in einer Radio Resource Control (RRC) Nachricht enthalten ist.

15. Empfangsende (1200) nach Anspruch 13, ferner umfassend:
ein zweites Speichermodul, das konfiguriert ist, um nur von dem Empfangsende unterstützte Wörterbücher in dem Empfangsende zu speichern, oder alle in einem Netzwerk vorhandenen Wörterbücher in dem Empfangsende zu speichern.

## Revendications

1. Procédé de transmission d'un message de plan de commande, appliqué à une extrémité de transmission, comprenant les étapes consistant à :
compresser (201) un message de plan de commande en utilisant un dictionnaire pris en charge par l'extrémité de transmission ; et
transmettre (202), à une extrémité de réception, le message de plan de commande qui est compressé en utilisant le dictionnaire et des informations d'identification du dictionnaire, dans lequel les informations d'identification sont transmises avec le message de plan de commande qui est compressé ;
dans lequel la transmission (202), à l'extrémité de réception, du message de plan de commande qui est compressé en utilisant le dictionnaire et les informations d'identification du dictionnaire comprend l'étape consistant à : transmettre le message de plan de commande qui est compressé en utilisant le dictionnaire et les informations d'identification du dictionnaire à l'extrémité de réception par l'intermédiaire d'une porteuse de signalisation dédiée ;
dans lequel, avant la transmission du message de plan de commande qui est compressé en utilisant le dictionnaire et les informations d'identification du dictionnaire à l'extrémité de réception par l'intermédiaire de la porteuse de signalisation dédiée, le procédé comprend en outre les étapes consistant à : obtenir la porteuse de signalisation dédiée configurée par l'extrémité de réception, ou, configurer la porteuse de signalisation dédiée pour l'extrémité de réception.

2. Procédé selon la revendication 1, dans lequel les informations d'identification du dictionnaire sont comprises dans un en-tête de protocole de convergence des données par paquets (PDCP).

3. Procédé selon la revendication 1, dans lequel les informations d'identification du dictionnaire sont comprises dans un message de contrôle de ressources radio (RRC).

4. Procédé selon la revendication 1, dans lequel avant la compression (201) du message de plan de commande en utilisant le dictionnaire pris en charge par l'extrémité de transmission, le procédé comprend en outre l'étape consistant à :
stocker, dans l'extrémité de transmission, uniquement des dictionnaires pris en charge par l'extrémité de transmission, ou stocker, dans l'extrémité de transmission, tous les dictionnaires existant dans un réseau.

5. Procédé selon la revendication 1, dans lequel dans un cas où l'extrémité de transmission est un équipement utilisateur et l'extrémité de réception est un dispositif de réseau, avant la transmission du message de plan de commande, qui est compressé en utilisant le dictionnaire et les informations d'identification du dictionnaire, à l'extrémité de réception par l'intermédiaire de la porteuse de signalisation dédiée, le procédé comprend en outre l'étape consistant à :
transmettre (401) des informations d'indication au dispositif de réseau, et obtenir (402) la porteuse de signalisation dédiée configurée par le dispositif de réseau, dans lequel les informations d'indication sont utilisées pour indiquer que l'équipement utilisateur prend en charge l'utilisation de la porteuse de signalisation dédiée pour transmettre une signalisation compressée ; ou,
dans lequel dans un cas où l'extrémité de transmission est un dispositif de réseau et l'extrémité de réception est un équipement utilisateur, avant la transmission du message de plan de commande qui est compressé en utilisant le dictionnaire et les informations d'identification du dictionnaire à l'extrémité de réception par l'intermédiaire de la porteuse de signalisation dédiée, le procédé comprend en outre les étapes consistant à :
recevoir (501) des informations d'indication depuis l'équipement utilisateur, et
configurer (502) la porteuse de signalisation dédiée pour l'équipement utilisateur, dans lequel les informations d'indication sont utilisées pour indiquer que l'équipement utilisateur prend en charge l'utilisation de la porteuse de signalisation dédiée pour transmettre une signalisation compressée.

6. Procédé de réception d'un message de plan de commande, appliqué à une extrémité de réception, comprenant les étapes consistant à :
recevoir (301), à partir d'une extrémité de transmission, un message de plan de commande qui est compressé en utilisant le dictionnaire et des informations d'identification du dictionnaire, dans lequel les informations d'identification sont transmises avec le message de plan de commande qui est compressé ;
déterminer (302) le dictionnaire correspondant aux informations d'identification du dictionnaire ; et
décompresser (303), sur la base du dictionnaire, le message de plan de commande qui est compressé en utilisant le dictionnaire, pour obtenir le message de plan de commande ;
dans lequel la réception (301), depuis l'extrémité de transmission, du message de plan de commande qui est compressé en utilisant le dictionnaire et les informations d'identification du dictionnaire comprend : la réception, par l'intermédiaire d'une porteuse de signalisation dédiée, depuis l'extrémité de transmission, du message de plan de commande qui est compressé en utilisant le dictionnaire et les informations d'identification du dictionnaire ;
dans lequel avant la réception, par l'intermédiaire de la porteuse de signalisation dédiée, depuis l'extrémité de transmission, du message de plan de commande qui est compressé en utilisant le dictionnaire et les informations d'identification du dictionnaire, le procédé comprend en outre les étapes consistant à : configurer la porteuse de signalisation dédiée pour l'extrémité de transmission, ou obtenir la porteuse de signalisation dédiée configurée par l'extrémité de transmission.

7. Procédé selon la revendication 6, dans lequel les informations d'identification du dictionnaire sont comprises dans un en-tête de protocole de convergence des données par paquets (PDCP) ; ou
les informations d'identification du dictionnaire sont comprises dans un message de contrôle de ressources radio (RRC).

8. Procédé selon la revendication 6, dans lequel avant la réception (301), à partir de l'extrémité de transmission, du message de plan de commande qui est compressé en utilisant le dictionnaire et les informations d'identification du dictionnaire, le procédé comprend en outre l'étape consistant à : stocker, dans l'extrémité de réception, uniquement des dictionnaires pris en charge par l'extrémité de réception, ou stocker, dans l'extrémité de réception, tous les dictionnaires existant dans un réseau.

9. Extrémité de transmission (1100), comprenant :
un module de compression (1101), configuré pour compresser un message de plan de commande en utilisant un dictionnaire pris en charge par l'extrémité de transmission (1100) ; et
un module de transmission (1102), configuré pour transmettre, à une extrémité de réception, le message de plan de commande qui est compressé en utilisant le dictionnaire et des informations d'identification du dictionnaire, dans lequel les informations d'identification sont transmises avec le message de plan de commande qui est compressé ;
dans lequel le module de transmission (1102) est configuré pour transmettre le message de plan de commande, qui est compressé en utilisant le dictionnaire et les informations d'identification du dictionnaire, à l'extrémité de réception par l'intermédiaire d'une porteuse de signalisation dédiée ;
dans lequel l'extrémité de transmission (1100) comprend en outre : un premier module de configuration, configuré pour obtenir la porteuse de signalisation dédiée configurée par l'extrémité de réception, ou configurer la porteuse de signalisation dédiée pour l'extrémité de réception.

10. Extrémité de transmission (1100) selon la revendication 9, dans laquelle les informations d'identification du dictionnaire sont comprises dans un en-tête de protocole de convergence de données par paquets (PDCP).

11. Extrémité de transmission (1100) selon la revendication 9, dans lequel les informations d'identification du dictionnaire sont comprises dans un message de contrôle de ressources radio (RRC).

12. Extrémité de transmission (1100) selon la revendication 9, comprenant en outre :
un premier module de stockage, configuré pour stocker uniquement des dictionnaires pris en charge par l'extrémité de transmission dans l'extrémité de transmission, ou pour stocker tous les dictionnaires existants dans un réseau dans l'extrémité de transmission.

13. Extrémité de réception (1200) comprenant :
un module de réception (1201), configuré pour recevoir, à partir d'une extrémité de transmission, un message de plan de commande qui est compressé en utilisant le dictionnaire et des informations d'identification du dictionnaire, dans lequel les informations d'identification sont transmises avec le message de plan de commande qui est compressé ;
un module de détermination (1202), configuré pour déterminer le dictionnaire correspondant aux informations d'identification du dictionnaire ; et
un module de décompression (1203), configuré pour décompresser, sur la base du dictionnaire, le message de plan de commande qui est compressé à l'aide du dictionnaire, pour obtenir le message de plan de commande ;
dans lequel le module de réception (1201) est configuré pour recevoir, par l'intermédiaire d'une porteuse de signalisation dédiée, depuis l'extrémité de transmission, le message de plan de commande qui est compressé en utilisant le dictionnaire et les informations d'identification du dictionnaire ;
dans lequel l'extrémité de réception (1200) comprend en outre : un second module de configuration, configuré pour configurer la porteuse de signalisation dédiée pour l'extrémité de transmission, ou pour obtenir la porteuse de signalisation dédiée configurée par l'extrémité de transmission.

14. Extrémité de réception (1200) selon la revendication 13, dans laquelle les informations d'identification du dictionnaire sont comprises dans un en-tête de protocole de convergence de données par paquets (PDCP) ; ou
les informations d'identification du dictionnaire sont comprises dans un message de contrôle de ressources radio (RRC).

15. Extrémité de réception (1200) selon la revendication 13, comprenant en outre :
un second module de stockage, configuré pour stocker uniquement des dictionnaires pris en charge par l'extrémité de réception dans l'extrémité de réception, ou pour stocker tous les dictionnaires existants dans un réseau dans l'extrémité de réception.
